(19) **Europäisches Patentamt**

**European Patent Office**

**Office européen des brevets**

(11) **EP 0 626 683 B1**

(12) **EUROPEAN PATENT SPECIFICATION**

(45) Date of publication and mention
of the grant of the patent:
**11.08.1999   Bulletin 1999/32**

(51) Int Cl.⁶: **G11B 7/26**

(21) Application number: **94303826.5**

(22) Date of filing: **26.05.1994**

(54) **Microwave processing apparatus and process for producing an inorganic dielectrique film**

Bearbeitungsgerät mittels Mikrowellen und Verfahren zur Herstellung eines anorganischen dielektrischen Films

Appareil de traitement par des micro-ondes et procédé de fabrication d'un film inorganique et diélectrique

(84) Designated Contracting States:
**DE FR GB IT NL**

(30) Priority: **27.05.1993   JP   12627593**

(43) Date of publication of application:
**30.11.1994   Bulletin 1994/48**

(73) Proprietor: **CANON KABUSHIKI KAISHA
Tokyo (JP)**

(72) Inventors:
  • **Takada, Kunio, c/o Canon Kabushiki Kaisha
    Shimomaruko, Ohta-ku, Tokyo (JP)**
  • **Suzuki, Nobumasa, c/o Canon Kabushiki Kaisha
    Shimomaruko, Ohta-ku, Tokyo (JP)**
  • **Miyakoshi, Toshimori,
    c/o Canon Kabushiki Kaisha
    Shimomaruko, Ohta-ku, Tokyo (JP)**

(74) Representative:
  **Beresford, Keith Denis Lewis et al
  BERESFORD & Co.
  2-5 Warwick Court
  High Holborn
  London WC1R 5DJ (GB)**

(56) References cited:
  **EP-A- 0 337 445**

  • **DATABASE WPI Week 8942, Derwent
    Publications Ltd., London, GB; AN 89-303909 &
    JP-A-1 223 644 (HITACHI K K) 6 September 1989**
  • **PATENT ABSTRACTS OF JAPAN vol. 15, no. 226
    (P-1213) 10 June 1991 & JP-A-03 066 043
    (NIPPON TELEGRAPH & TELEPHONE CORP) 20
    March 1991**

**Description**

BACKGROUND OF THE INVENTION

Field of the Invention

This invention relates to a microwave processing apparatus medium and a process for the production of inorganic dielectric films. More particularly, it relates to the production of an optical recording medium comprising a substrate and an inorganic dielectric film formed thereon.

Related Background Art

In recent years, there is an increasing demand for recording mediums having a large recording capacity and enabling a high-speed data transfer as computer memories and image information memories. As recording mediums that can answer such a demand, optical recording mediums for recording and reproducing information by the use of laser light as exemplified by magneto-optical recording mediums and phase change recording mediums are energetically developed.

More specifically, the magneto-optical recording mediums have a system in which information is recorded and reproduced by utilizing the characteristic that the polarization plane of laser light being reflected has a rotational direction which differs depending on the direction of magnetization when the polarized laser light is shed on the surface of a recording layer containing a magnetic material (i.e., the magnetic Kerr effect).

As for the phase change recording mediums, they have a system in which information is recorded and reproduced by utilizing the reversible phase transformation between an amorphous state and a crystalline state, caused when, for example, laser light is shed on a recording layer containing Te and the optical properties different from each other which are shown in the respective states.

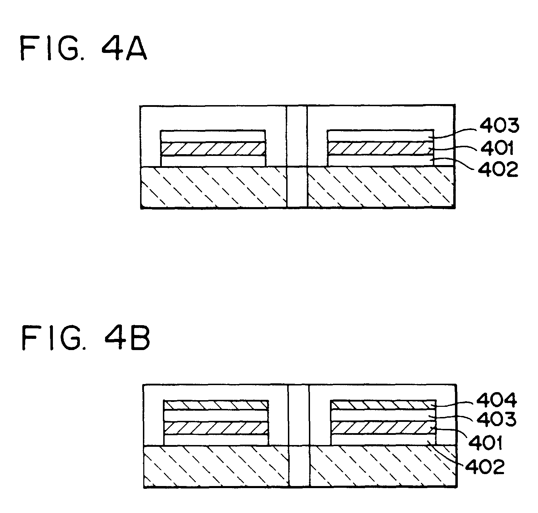

These optical recording mediums employ such layer configuration that in order to obtain reproducing signals having a greater C/N ratio, for example, an inorganic dielectric film is provided between a recording film and a substrate so that the reproducing signals can be amplified utilizing an optical interference effect (i.e., the enhancement effect), or, as shown in Fig. 4A, a recording film 401 is held between inorganic dielectric films 402 and 403 so that the reproducing light can be amplified and, at the same time, they can serve as protective films of the recording film 401. Another configuration is also known in which, as shown in Fig. 4B, a reflective layer 404 is additionally provided on the inorganic dielectric film 403 in order to more improve the interference effect.

To form such inorganic dielectric films, thin films of, for example, $Si_3N_4$, SiC, SiO, amorphous Si (a-Si), AlN, $Al_2O_3$, $TiO_2$, $Ta_2O_5$ and ZnS have been conventionally used.

Performances as exemplified by C/N ratios of reproducing signals and stability with the passage of time of recording films of the magneto-optical recording mediums and phase change optical recording mediums making use of such inorganic dielectric films greatly depend not only on the properties of recording films as previously stated, but also on the properties of the inorganic dielectric films. Accordingly, in domestic and foreign research institutions, research and development are energetically made on materials and production processes for dielectrics having a great enhancement effect on reproducing signals and a superior protective performance on recording layers so that the optical recording mediums can be made to have a higher performance. For example, it is attempted to form inorganic dielectric films for optical recording mediums by forming AlN or SiN by reactive sputtering carried out in an atmosphere of $N_2$ using an Al target or Si target as disclosed in Japanese Patent Publication No. 2-15929, or by ECR (electron cyclotron resonance) plasma-assisted CVD (chemical vapour deposition) as disclosed in Japanese Patent Application Laid-open Nos. 3-66043, 3-69033 and 4-30343.

In recent years, however, in the trend toward the lower-cost production of optical recording mediums, it is sought to improve the film forming rate for the formation of inorganic dielectric films.

Under such circumstances, in the above film forming processes for the inorganic dielectric films, the reactive sputtering must be greatly improved in the power to be applied to the target, in order to improve the film deposition rate. In such a case, however, abnormal discharge onto the target tends to occur because of the concentration of charges on the target, and hence it has been difficult to stably form high-quality inorganic dielectric films for optical recording mediums. On the other hand, the plasma-assisted CVD makes it possible to form films at a higher rate than the reactive sputtering. The former, however, has its own limit in the film formation rate in order to form inorganic dielectric films with good enhancement effect and recording layer protective performance without causing inclusion of a stress that may cause a deformation of optical recording mediums, and has been unsatisfactory for achieving the lower-cost production of optical recording mediums.

Moreover, in the conventional plasma-assisted CVD, a uniform plasma density can only be attained in a limited region inside a reaction chamber, and it becomes necessary to make a film forming apparatus larger when uniform inorganic dielectric films are simultaneously formed on a plurality of substrates, where it has been not easy to achieve the low-cost production of optical recording mediums when the plasma-assisted CVD is used.

EP-A-0 337 445 discloses a microwave plasma CVD apparatus including a plasma generation chamber and a microwave waveguide. A gas feed means is provided for the chamber. The apparatus is used to deposit an inorganic layer on an organic substrate.

SUMMARY OF THE INVENTION

The present invention was made taking account of the problems discussed above. A main object of the present invention is to provide a process for producing at a low cost an optical recording medium that can stably maintain the C/N ratio of reproducing signals at a high level while preventing deformation such as warpage or deflection.

Another object of the present invention is to provide an optical recording medium that can enjoy less deformation such as warpage or deflection, can achieve a high C/N ratio of reproducing signals and also can have a recording layer promising a superior stability with the passage of time.

The present inventors made extensive studies in order to achieve the above objects. As a result, they have discovered that an inorganic dielectric film having superior enhancement effect and recording layer protective performance and having a low internal stress and a high quality can be formed at a high rate and also in a film thickness uniform over a large area can be obtained when formed using a microwave plasma processing device so constructed that microwaves are guided into a plasma chamber through a microwave guide means having an endless ring waveguide. They have thus accomplished the present invention.

According to the present invention, there is provided a microwave processing apparatus comprising a plasma chamber; gas feeding means and a waveguide provided with a microwave introducing portion, the apparatus being characterised in that the waveguide is an endless waveguide surrounding the plasma chamber, the endless waveguide comprising an inner wall and an outer wall between which a cavity is provided, wherein the inner wall has a plurality of slots at given intervals in order to enable the introduction of microwaves into the plasma chamber; and in that the apparatus comprises a dividing block on the inner wall at a position so as to be collided with by the microwaves introduced into the endless waveguide from the microwave introducing portion thereby to divide the introduced microwaves and to propagate the microwaves along both directions of the endless waveguide.

In a further aspect of the invention, there is provided a process for producing an inorganic dielectric film on a substrate by microwave plasma assisted CVD using an apparatus according to the invention.

The invention also provides a process for producing an optical recording medium comprising a recording film and an inorganic dielectric film produced using an apparatus according to the invention.

BRIEF DESCRIPTION OF THE DRAWINGS

Fig. 1 is a schematic illustration of an apparatus for producing an optical recording medium according to the present invention.

Figs. 2A and 2B are schematic illustrations of a film forming device for forming inorganic dielectric films of optical recording mediums according to the present invention, in which Fig. 2A is a schematic perspective illustration of the inorganic dielectric film forming device, and Fig. 2B is a schematic cross section of the film forming device shown in Fig. 2A.

Figs. 3A and 3B are schematic illustrations of an endless ring waveguide of the film forming device shown in Figs. 2A and 2B, in which Fig. 3A is a schematic perspective illustration of the endless ring waveguide of the film forming device shown in Figs. 2A and 2B, and Fig. 3B is a cross section along the line A-A in Fig. 3A.

Figs. 4A and 4B are schematic cross sections of optical recording mediums.

Fig. 5 is a schematic cross section of another embodiment of the endless ring waveguide usable in the present invention.

Figs. 6A to 6C illustrate another embodiment of the film forming device for forming inorganic dielectric films of optical recording mediums according to the present invention, in which Fig. 6A is a schematic perspective view of the film forming device for forming inorganic dielectric films of optical recording mediums according to the present invention, constructed in a rectangular shape, Fig. 6B is a cross section along the line B-B in Fig. 6A, and Fig. 6C is a cross section along the line C-C in Fig. 6A.

Figs. 7A and 7B illustrate another embodiment of the film forming device for forming inorganic dielectric films of optical recording mediums according to the present invention, in which Fig. 7A is a schematic perspective view of the film forming device for forming inorganic dielectric films of optical recording mediums according to the present invention, constructed in a rectangular shape, and Fig. 7B is a cross section along the line D-D in Fig. 7A.

Fig. 8 is a schematic cross section of a conventional device for forming an inorganic dielectric film for an optical recording medium.

Fig. 9 is a schematic cross section of an embodiment of the endless ring waveguide according to the present invention.

DETAILED DESCRIPTION OF THE PREFERRED EMBODIMENTS

The present invention will be described below with reference to the accompanying drawings.

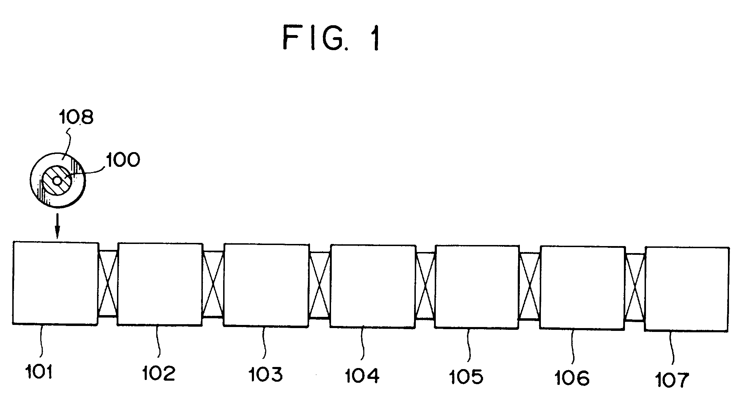

Fig. 1 is a schematic plan view of an in-line type continuous film forming apparatus for forming inorganic dielectric films and a recording film according to the present invention, applied to an embodiment of the process for producing the optical recording medium as shown in Fig. 4B. In Fig. 1, reference numeral 101 denotes a chamber into which a substrate 100 is fed; 102, a degassing chamber; 103 and 105, film forming chambers in which inorganic dielectric films 402 and 403 are formed; 104, a film forming chamber in which a recording film 401 as exemplified by a magneto-optical recording film is formed; and 106, a film forming chamber in which a reflective film is formed. Reference numeral 107 denotes a chamber from which a substrate with the recording film 401 and inorganic dielectric films 402 and 403 formed thereon are taken out. Doors (not shown) that can be opened or closed are also provided between the respective chambers, and a substrate holder 108 for carrying the substrate 100 is set to be movable from the substrate feeding chamber 101 to the substrate takeout chamber 107 in order.

The optical recording medium substrate 100 is transported from the substrate feeding chamber 101 toward the substrate takeout chamber 107, in the course of which the degassing of the substrate 100, the formation of the inorganic dielectric film 402, the formation of the recording film 401, the formation of the inorganic dielectric film 403 and the formation of the reflective layer 44 are carried out in order, so that an optical recording medium is formed which comprises the substrate provided thereon with the recording film 401, the inorganic dielectric films 402 and 403 and the reflective layer 404.

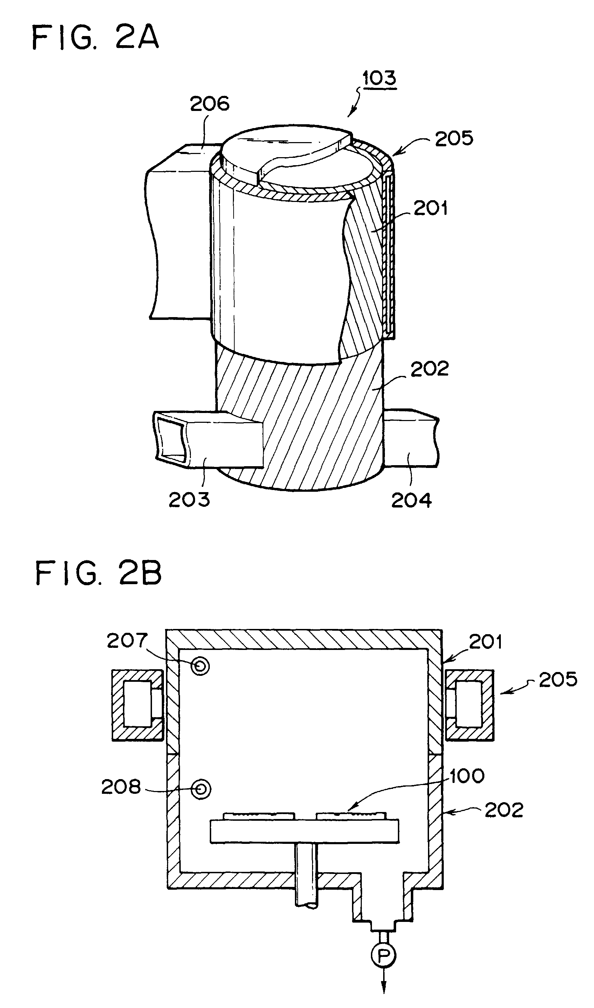

In this embodiment, the film forming chambers 103 and 105 are each constituted of a microwave plasma-assisted CVD film forming device comprising a microwave guide means having an endless ring waveguide. Then, Fig. 2A is a schematic perspective view of such a microwave plasma-assisted CVD film forming device of which the film forming chamber 103 (or 105) is constituted, and Fig. 2B is a schematic cross-sectional view of the CVD device in the direction falling at right angles to the direction in which the substrate is transported.

In the aforesaid Figs. 2A and 2B, reference numeral 201 denotes a plasma chamber; 202, a film forming chamber; 203, a substrate transport path extending from the degassing chamber 102 to the inorganic dielectric film forming chamber 103; and 204, a substrate transport path extending from the film forming chamber 103 to the recording film forming chamber 104. Reference numeral 205 denotes an endless ring waveguide provided along the periphery of the plasma chamber; 206, a microwave introducing portion through which microwaves are introduced into the endless ring waveguide 205; and 207 and 208, gas feeding means through which gases are fed into the plasma chamber 201 and the film forming chamber 202.

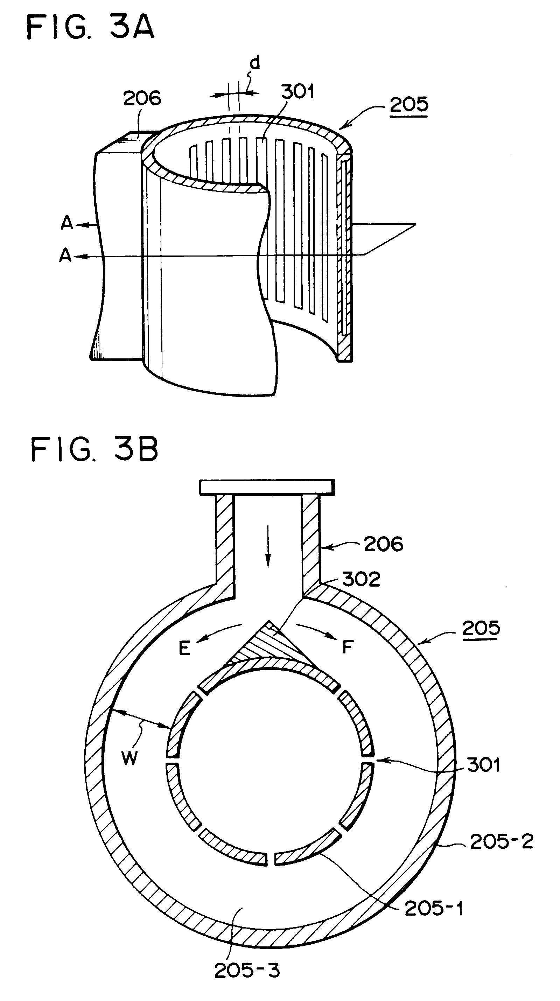

Fig. 3A is a schematic perspective view of the microwave guide means used in the plasma-assisted CVD device shown in Figs. 2A and 2B, and Fig. 3B is a cross section along the line A-A in Fig. 3A. In Fig. 3A, reference numerals 205 and 206 denote the endless ring waveguide and the microwave introducing portion, respectively, as described above. To the microwave introducing portion 206, microwave generating means as exemplified by a tuner, a directional coupler, an isolator and a microwave power source are connected.

The endless ring waveguide 205 used in the present invention has an inner wall 205-1 and an outer wall 205-2, which are so constructed that they form a given empty space 205-3. The inner wall of the endless ring waveguide is provided with slots 301 through which microwaves are guided into the plasma chamber.

When, for example, $SiN_x$ films are formed using the plasma-assisted CVD device thus constructed, the insides of the plasma chamber 201 and film forming chamber 202 are evacuated by means of a vacuum pump. Thereafter, $N_2$ gas as a reaction gas is fed into the plasma chamber 201 from the gas feeding means 207 and also $SiH_4$ gas as a starting material gas is fed in the film forming chamber 202, in the course of which microwaves are introduced into the endless ring waveguide from the microwave introducing portion 206 and the microwaves are guided into the plasma chamber 201 from the slots made in the inner wall of the endless ring waveguide. Thus, a plasma originating mainly from the $N_2$ gas can be generated in the plasma chamber 201 and the $SiH_4$ gas is ionized in the film forming chamber by the action of the energy of the plasma, so that the $SiN_x$ film can be formed on the substrate.

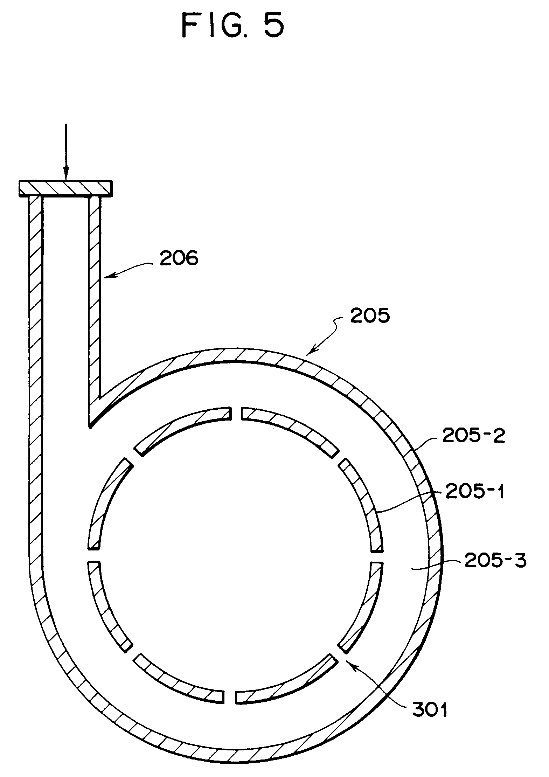

In the present invention, the microwave guide means may be constructed in the manner that, as shown in Fig. 3B, the ring waveguide 205 and the microwave introducing portion 206 are so provided that microwaves are introduced in the direction falling at right angles to the outer wall of the ring waveguide, or in the manner that, as shown in Fig. 5, microwaves are introduced in the direction tangential to the outer wall of the ring waveguide.

In combination with the embodiment in which, as shown in Fig. 3B, the ring waveguide 205 and the microwave introducing portion 206 are so provided that a microwave is introduced in the direction falling at right angles to the outer wall of the ring waveguide, the microwave introduced into the ring waveguide from the microwave introducing portion may be divided into two ways so that the microwave is propagated in both directions (see arrows E and F in Fig. 3B) of the ring waveguide 205. In such a case, an interference wave can be produced inside the ring waveguide by the mutual action of the microwave thus divided, so that the intensity of microwave that usually becomes lowest at the part opposing to the microwave introducing portion can be compensated and hence the microwave can be uniformly guided into the plasma chamber, making it possible to form the inorganic dielectric films for optical recording mediums in a more uniform thickness and a higher quality.

The microwave may be divided in two directions by a method in which, as shown in Fig. 3B, a dividing block 302 having the shape of a triangular pillar in its cross section and comprised of a microwave-reflective material (e.g., a metal) is placed on the inner wall 205-1 of the ring waveguide at a part against which the microwave coming from the microwave introducing portion 206 collide, or a method in which the inner wall 205-1 itself of the microwave introducing portion has been molded in such a shape that it functions as the above dividing block.

In this method, the inorganic dielectric films formed can be more improved in their performance and uniformity when the dividing block has a shape of enabling equal division of a microwave, as exemplified by a dividing block provided on the inner wall 205-1 in such a manner that the cross-sectional shape of the triangular pillar is an isosceles triangle, the direction of a perpendicular line dropped toward the base of the triangle from the vertex held between the two equal sides thereof is in agreement with the direction in which the microwaves are introduced from the microwave introducing means, and also the vertex projects in the direction of the introduction of microwaves, or when an endless ring waveguide that functions in such a manner is used. In this embodiment, it is preferable for the triangle to have an angle of 90° at its vertex because such a shape makes it possible for the microwaves introduced into the ring waveguide 205 to undergo interference in a good efficiency. It is also preferable in this embodiment to make the length of longer sides of the dividing block equal to the distance between the inner wall and the outer wall of the ring waveguide.

There are no particular limitations on the materials for the dividing block used herein, so long as they are capable of reflecting the microwave, as stated above. For example, metals or the like can be used. A dividing block made of aluminum or glass coated with chromium or aluminum on its surface may be used when microwave reflection efficiency and durability are taken into account.

With regard to the distance (d) between the plurality of slots 301 made in the inner wall of the endless ring waveguide used in the present invention, there are no particular limitations thereon so long as a microwave capable of achieving a plasma density (e.g., $10^{11}$ particles/$cm^3$ or more, and particularly $10^{12}$ particles/$cm^3$ or more) high enough to form the inorganic dielectric film can be introduced. For example, when the endless ring waveguide is constructed to have the dividing block as described above, the distance (d) between the slots may preferably be set at 1/2 or its integer times (i.e. 1/2 x n where n is an integer) of waveguide wavelength (wavelength of the microwave propagated through the waveguide) so that the slots come in agreement with the "loop" of the interference wave generated in the endless ring waveguide. That is, such construction makes it possible to form high-quality inorganic dielectric films for optical recording mediums in a uniform state over a large area and is very effective for decreasing production cost of the optical recording mediums.

With regard to the shape of the slots 301 provided in the microwave guide means of the present invention, slots with any shape can be employed so long as the microwaves can be introduced through the slots, irrespective of whether they have longer sides parallel or inclined to the direction of the propagation of microwaves, or are not rectangular but either round or polygonal, or in the form of dumbbells or asters. However, taking account of efficient introduction of microwaves and readiness to control their leakage probability, the slots may preferably have such a shape that their longer sides are perpendicular to the direction of the propagation of a microwave. For example, rectangular slots of 40 mm to 60 mm × 1 mm to 5 mm are most suitable.

With regard to the length ($\ell$) of each slot 301, it can also be a factor that defines the leakage probability and besides controls the density of the plasma generated inside the plasma chamber. Its value may be appropriately set so that the plasma density inside the plasma chamber may satisfy the above value, in accordance with the power of microwaves introduced through the microwave guide means, the state of the microwave in the ring waveguide and also the position of the slots. Stated specifically, when the ratio of the waveguide peripheral length to the waveguide wavelength of the ring waveguide 205 is large, the microwave may preferably be propagated in a larger wave number so that a good microwave can also be leaked from slots positioned opposite to the microwave introducing portion of the ring waveguide. For that purpose, it is preferred to make the length of each slot smaller to decrease the leakage probability. On the other hand, when the ratio of the waveguide peripheral length to the waveguide wavelength of the ring waveguide 205 is small, it is preferred to make the length of each slot larger to increase the leakage probability so that the microwave may not leak in excess from the slots positioned opposite to the microwave introducing portion of the ring waveguide.

Stated more specifically, when the ratio of the waveguide peripheral length to the waveguide wavelength of the ring waveguide is 3 to 24, each slot may most preferably have a length of 1/4 to 3/8 of the waveguide wavelength. This enables uniform formation of high-quality inorganic dielectric films for optical recording mediums over the substantially entire region of the film forming chamber, and is preferable for more decreasing the production cost of optical recording mediums.

Use of such a device according to the present embodiment also enables formation of substantially uniform and high-quality inorganic dielectric films for optical recording mediums in spite of the positioning of the substrates in the chamber, and hence the device can be particularly preferably used in the in-line type film forming apparatus for producing optical recording mediums as shown in Fig. 1.

In the present invention, there are no particular limitations on the materials for the endless ring waveguide. Its inner wall and outer wall may preferably be comprised of such materials that can prevent any propagation loss of a microwave, and any materials can be used so long as they have a sufficient mechanical strength and their surfaces are covered with a conductive layer to prevent penetration of a microwave, as exemplified by insulating materials including metals such as Cu, Al, Fe, Ni, alloys thereof, various types of glass, quartz, silicon nitride, alumina, acrylate, polycarbonate, polyvinyl chloride and polyimide whose surfaces are covered with a metal thin film of Al, W, Mo, Ti, Ta, Cu, Ag or the like. In particular, the ring waveguide may be made of stainless steel, and the inner surface of the waveguide may be coated with copper which is further coated with silver. Such constitution can be preferably used.

The endless ring waveguide used in the present invention may have a polygonal shape or other shape, depending on the shape of the plasma chamber. The empty space inside the ring waveguide may have any size and any shape in its cross section, including a circle, a semicircle and other shape, any of which can be used so long as the microwave can be propagated. Its waveguide peripheral length may be about integer times the waveguide wavelength of the microwave, ranging from 3 to 24 times. This is preferable in order to make uniform the plasma introduced into the plasma chamber.

A magnet may also be provided on the inner wall of the endless ring waveguide at its surface on the side opposing to the plasma chamber so that a magnetic field is produced in the vicinity of, in particular, the inner wall of the chamber. This makes it possible to prevent inorganic dielectric films from adhering to the inner wall of the plasma chamber, and is preferable in order to improve film forming efficiency.

In the endless ring waveguide, cooling means may also be preferably provided in order to prevent the inside of the waveguide from being oxidized when heated with a microwave. As this cooling means, for example, air cooling means or water cooling means can be used.

In the embodiment described above, the slots made in the inner wall of the ring waveguide are described as apertures made in the wall. They, however, are by no means limited to such an embodiment, and may be replaced with a constitution in which dielectric windows capable of transmitting microwaves are provided in the wall.

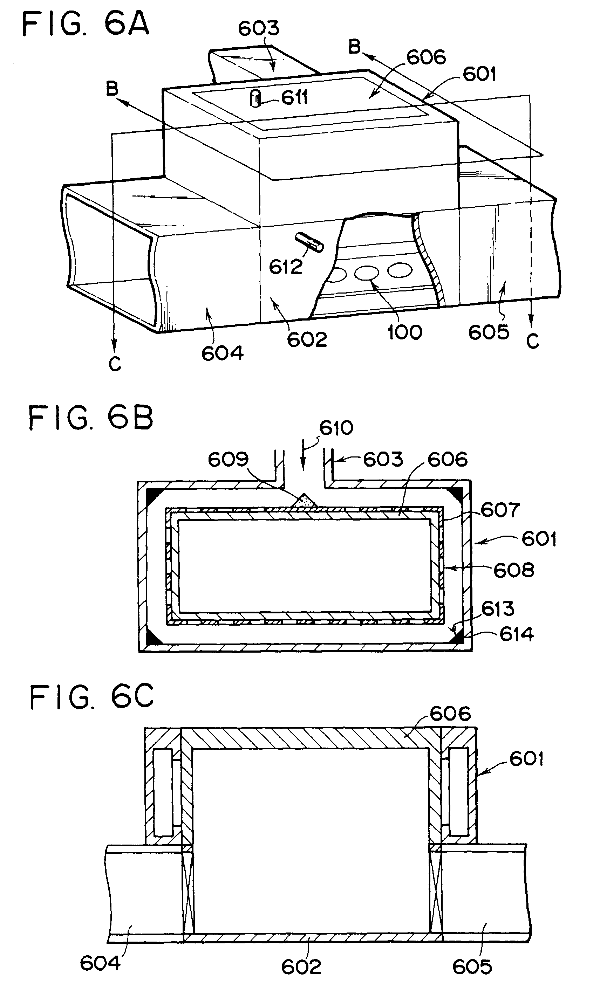

Fig. 6A is a schematic perspective view to show another embodiment of the plasma-assisted CVD device that can be used to form inorganic dielectric films in the process for producing the optical recording medium of the present invention. This embodiment is characterized by a plasma chamber made to have a rectangular shape and an endless ring waveguide provided around this plasma chamber.

In Fig. 6A, reference numeral 601 denotes an endless ring waveguide surrounding the plasma chamber; 602, a film forming chamber provided right beneath the plasma chamber; and 603, a microwave introducing portion from which the microwave is introduced into the microwave guide means. Reference numerals 604 and 605 denote paths through which, for example, disk substrates 100 are transported; 611, a means for feeding gas into the plasma chamber; and 612, a means for feeding gas into the film forming chamber.

Fig. 6B is a cross section along the line B-B in Fig. 6A, and Fig. 6C is a cross section along the line C-C in Fig. 6A. In Figs. 6B and 6C, reference numeral 606 denotes a plasma chamber made of, for example, quartz; 607, an inner wall of the endless ring waveguide, in which slots 608 are made at given intervals. Reference numeral 609 denotes a dividing block for dividing in both directions inside the endless ring waveguide the microwave introduced from the microwave introducing portion 603 in the direction shown by an arrow 610.

Using the plasma-assisted CVD device constructed in this way, inorganic dielectric films can be formed in the same manner as previously described. That is, the insides of the plasma chamber and film forming chamber are evacuated to a vacuum of about $1 \times 10^{-4}$ Pa by means of a vacuum pump (not shown), and thereafter, gases are fed into the plasma chamber from gas feeding means 611 and 612 and adjusted to desired pressure, in the course of which a microwave with a desired power is introduced into the endless ring waveguide from a microwave power source. Even when such rectangular plasma chamber and film forming chamber are used, the employment of such an endless ring waveguide, in particular, the endless ring waveguide provided with the dividing block makes it possible to form high-quality inorganic dielectric films for optical recording mediums having uniform thickness on the respective substrates arranged in the film forming chamber. Hence, when films are simultaneously formed on a plurality of substrates, the plasma chamber and the film forming chamber may only be constructed in such a size that a plurality of substrates can be received, and thus the film forming efficiency can be improved.

In the case when the rectangular endless ring waveguide is used as described above, it is preferable to provide, as shown in Fig. 6B, reflective blocks 613 that can promote vertical reflection at right-angled corners 614 inside the ring waveguide to improve propagation efficiency of the microwave. The reflective blocks 614 may be comprised of blocks each having a right-angled isosceles triangle in a cross section and in which a length (k) of the longer side serving as a reflective surface is twice a width (w) between the outer wall and inner wall of the ring waveguide, and may be provided in the manner that their two equal sides come in contact with the right-angled corners 613, respectively. This is preferable from the viewpoint of an improvement in propagation efficiency.

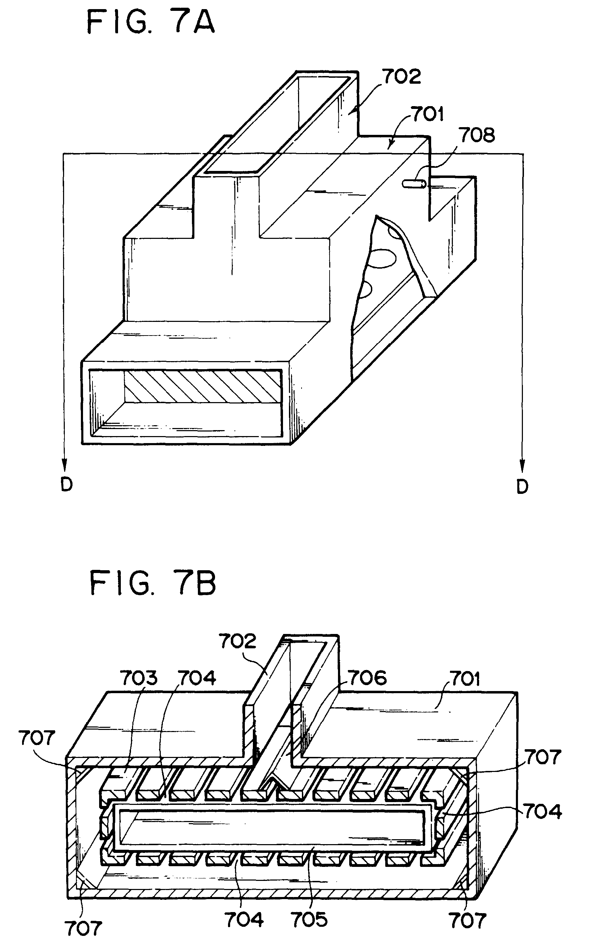

Fig. 7A and its cross section Fig. 7B along the line D-D in Fig. 7A illustrate still another embodiment of the plasma-assisted CVD device used in the process for producing the optical recording medium of the present invention, which is characterized in that the film forming chamber and plasma chamber in the CVD device shown in Figs. 6A to 6C are integrally constructed. More specifically, in Figs. 7A and 7B, reference numeral 701 denotes an endless ring waveguide; 702, a microwave introducing portion; 703, an inner wall of the ring waveguide; 704, slots made in the inner wall; 705, a plasma chamber serving also as a film forming chamber; 706, a dividing block; 707, reflective blocks; and 708, a gas feeding means.

Using this device, inorganic dielectric films can be formed in the same manner as previously described, except that the CVD device of the present embodiment may preferably be used to form inorganic dielectric films that can be formed using a single gas species as in the formation of Si semiconductor films as described later.

As the gas used to form the inorganic dielectric films for optical recording mediums by the plasma-assisted CVD of the present invention, when, for example, films of silicon type semiconductors such as a-Si and SiC are formed as the inorganic dielectric films, it is preferable to use the starting material gas containing Si atoms, at least one of which is gaseous at normal temperature and normal pressure or is readily gasifiable, exemplified by inorganic silanes such as $SiH_4$ and $Si_2H_6$, organic silanes such as tetraethylsilane (TES), tetramethylsilane (TMS) and dimethylsilane (DMS) and halosilanes such as $SiF_4$, $Si_2F_6$, $SiHF_3$, $SiH_2F_2$, $SiCl_4$, $Si_2Cl_6$, $SiHCl_3$, $SiH_2Cl_2$, $SiH_3Cl$ and $SiCl_2F_2$. When films of silicon compounds such as $SiN_x$, $SiO$ and $SiO_2$ are formed as the inorganic dielectric films, it is preferable to use under appropriate selection, as the Si atom-containing starting material gas, any of those which are gaseous at normal temperature and normal pressure or are readily gasifiable, as exemplified by inorganic silanes such as $SiH_4$ and $Si_2H_6$, organic silanes such as tetraethoxylsilane (TEOS), tetramethoxylsilane (TMOS) and octamethylcyclotetrasilane (OMCTS) and halosilanes such as $SiF_4$, $Si_2F_6$, $SiHF_3$, $SiH_2F_2$, $SiCl_4$, $Si_2Cl_6$, $SiHCl_3$, $SiH_2Cl_2$, $SiH_3Cl$ and $SiCl_2F_2$, and as reaction gases those exemplified by $NH_3$, $N_2H_4$, hexamethyldisilazane (HMDS), $O_2$, $O_3$, $H_2O$, $NO$, $N_2O$ and $NO_2$.

When thin films of metal compounds such as AlN, $Al_2O_3$, $TiO_2$ and $Ta_2O_5$ are formed as the inorganic dielectric films, it is preferable to use under appropriate selection, as the metal atom-containing starting material gas, any of those exemplified by organic metals such as trimethyl aluminum (TMAl), triethyl aluminum (TEAl), triisobutyl aluminum (TIBAl) and dimethylaluminum hydride (DMAIH) and halogenated metals such as $AlCl_3$, $TiCl_3$ and $TaCl_5$, and as the reaction gas, those exemplified by $O_2$, $O_3$, $H_2O$, $NO$, $N_2O$, $NO_2$, $N_2$, $NH_3$, $N_2H_4$ and hexamethyldisilazane (HMDS).

When two kinds of gases, the starting material gas and the reaction gas, are used to form the inorganic dielectric film as stated above, it is preferable to feed the reaction gas and the starting material gas into each of the plasma chamber 201 and film forming chamber 202 shown in Figs. 2A and 2B. In particular, when the reaction gas is fed into the plasma chamber 201 from the gas feeding means 207 and the starting material gas is fed into the film forming chamber 202 from the gas feeding means 208, the internal stress in the inorganic dielectric films for optical recording mediums formed on the substrates can be more decreased, and also inorganic dielectric films that can provide high-quality optical recording mediums can be produced in a very good efficiency.

Conditions under which the inorganic dielectric films for optical recording mediums are formed using the plasma-assisted CVD devices according to the above various embodiments of the present invention will be described below. The microwave usable in the present invention may include an electromagnetic wave with a frequency ranging from 300 MHz to 300 GHz. In particular, an electromagnetic wave with a frequency of 2.45 GHz can be preferably used.

The power applied from the microwave power source may vary depending on the peripheral length of the ring waveguide and the types of the reaction gas and/or starting material gas. For example, when the peripheral length of the ring waveguide is 600 to 1,250 mm, this length corresponds to a length 3 to 24 times the waveguide wavelength, the length of each slot is 1/4 to 3/8 of the waveguide wavelength and an inorganic silane, organic silane or halosilane is used as the starting material gas, the power may preferably be set at from 0.5 to 5.0 kW, and particularly from 1.0 to 2.5 kW. As for the total pressure of the starting material gas or reaction gas or a mixed gas of these inside the plasma chamber and/or the film forming chamber, films may preferably be formed at a total pressure ranging from 0.5 to 5 Pa, and particularly preferably from 0.5 to 2 Pa.

In the process for producing the optical recording medium of the present invention, there are no particular limitations on the constitution other than that for the step in which the inorganic dielectric film is formed by the plasma-assisted CVD characterized in the present invention as described above. For example, the order of the steps of forming the inorganic dielectric films and the step of forming the optical recording film is by no means limited to the order in the in-line process shown in Fig. 1, and the films may be successively formed according to the desired constitution of the optical recording medium.

With regard to the step of forming the recording film, known film forming processes suited to the properties of materials used in recording films may used. Stated specifically, processes as exemplified by vacuum deposition, sputtering and wet coating may be used.

In the present invention, any recording films can be used without any particular limitations so long as they are recording films capable of recording and reproducing information upon irradiation with a light beam. In particular, it is preferable to use an amorphous magnetic film containing a rare earth element and/or a transition metal, for example, an amorphous magnetic film containing a rare earth element and/or a transition metal, comprised of Tb-Fe-Co, Gd-Fe-Co, Tb-Fe-Co-Cr, Gd-Fe-Co-Cr or the like, a magneto-optical recording film having a multi-layer thereof, and a recording film containing a calcogenide element as exemplified by Te. These films have a strong corrosion resistance and hence, since the inorganic dielectric film is required to have a particularly good recording layer protective performance, can more effectively facilitate the advantages attributable to the process for producing the optical recording medium of the present invention. Thus, they are preferred in this respect.

In the optical recording medium according to the present invention, the thickness of the inorganic dielectric film is determined in accordance with the materials and constitution for the recording layer and the properties of the inorganic dielectric film. For example, when two layers of inorganic dielectric films are so formed as to hold a magneto-optical recording film between them as shown in Figs. 4A and 4B, the inorganic dielectric film formed between the substrate and the magneto-optical recording film may preferably be in a thickness of about 100 to 1,500 Å, and the inorganic dielectric film formed on the magneto-optical recording film in a thickness of about 100 to 1,000 Å, taking account of the protection of the recording layer and the enhancement of Kerr rotational angles at the time of signal reproduction.

A protective layer may also be optionally provided on the recording layer, inorganic dielectric film or reflective layer of the optical recording medium obtained by its production process of the present invention. In such an instance, the protective layer can be formed, for example, by applying a photocurable resin on the recording layer in a given thickness (e.g., 10 to 30 μm), followed by irradiation with light to effect curing, or attaching a resin sheet having been molded in a given thickness (e.g., a polycarbonate resin sheet or a polyester resin sheet) onto the recording layer, inorganic dielectric film or reflective layer by the aid of an adhesive or a pressure-sensitive adhesive. In particular, when the resin sheet having been molded in a given thickness is used as the protective layer, the internal stress possessed by the protective layer can prevent the optical recording medium from its deformation. Hence, this is particularly preferable in the present invention.

As the substrate of the optical recording medium according to the present invention, any substrates commonly used as substrates for optical recording mediums can be used. For exmaple, it is possible to use substrates comprising glass, bisphenol polycarbonate resin or other modified polycarbonate resin or amorphous polyolefin resin.

As described above, the present invention makes it possible to form inorganic dielectric films for optical recording mediums, having superior enhancement effect and recording layer protective performance, at a rate much higher than film forming rate of conventional plasma-assisted CVD, so that it becomes possible to produce high-quality optical recording mediums at a low cost.

The present invention also makes it possible to form inorganic dielectric films for optical recording mediums in a uniform state and a high quality without regard to the position of substrates placed in the film forming chamber, so that optical recording mediums can be continuously produced with great ease and high-quality optical recording mediums can be produced at a lower cost.

EXAMPLE

The present invention will be described below in greater detail by giving Examples.

Example 1

On a doughnut-shaped disk substrate made of polycarbonate resin (trade name: IUPILON H4000; available from Mitsubishi Gas Chemical Company, Inc.) having an outer diameter of 86 mm, an inner diameter of 15 mm and a thickness of 1.2 mm and on one side of which a pregroove with a width of 0.6 μm, a pitch of 1.6 μm and a depth of 800 Å had been formed in a spiral, a first dielectric film comprising an amorphous silicon (a-Si:H) film of 72 nm thick, a recording layer comprising an amorphous Gd-Fe-Co magnetic layer of 10 nm thick, a superposed film comprising an amorphous Tb-Fe-Co magnetic layer of 20 nm thick, a second dielectric film comprising an a-Si:H film of 30 nm thick and a reflective layer comprising an Al film of 60 nm thick were superposed in order on its side on which the tracking groove had been formed, to obtain a magneto-optical disk. The films were formed in the following way.

In the first place, the in-line type film forming apparatus as shown in Fig. 1 was set up. In this film forming apparatus, the first and second a-Si:H film forming chambers 103 and 105 were each constituted of the plasma-assisted CVD device as shown in Figs. 2A and 2B.

The plasma-assisted CVD device used here was comprised of a cylindrical plasma chamber 201 with an outer diameter of 326 mm, an inner diameter of 320 mm and a length of 115 mm and a cylindrical film forming chamber 202 with an outer diameter of 326 mm, an inner diameter of 320 mm and a length of 210 mm, placed directly below chamber 206 which were joined together in the manner that their axes came in agreement with each other.

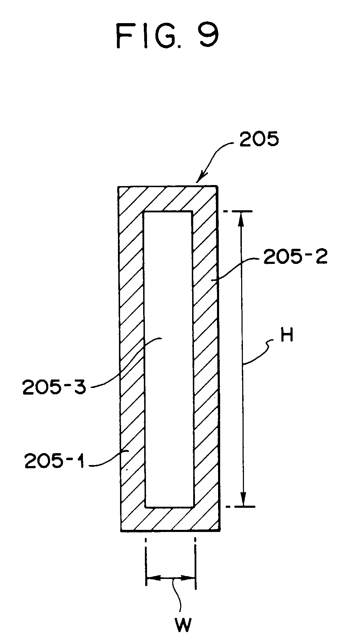

The ring waveguide 205 was comprised of a waveguide having an inside empty space with a cross-sectional size of 27 mm in width (W) and 96 mm in height (H) (see Fig. 9) and a center diameter of 354 mm, the same as those of a waveguide of the WRT-2 standard, made of stainless steel, whose inner surfaces were coated with copper and further coated thereon with silver in order to prevent propagation loss of microwave, and in the inner wall of which rectangular slots 301 of 42 mm long and 4 mm wide were made at intervals of about 40 mm to provide 28 (twenty eight) slots.

As the dividing block, a block having a cross section of a right-angled isosceles triangle, the longer side of which was 27 mm, the same as the width of the empty space of the waveguide 205, made of aluminum, was welded to the ring waveguide inner wall at the position opposing the microwave introducing portion so that the microwave is equally divided.

Next, a substrate holder 107 to which three sheets of disk substrates 100 were fitted in a row was put into the substrate feeding chamber 101 of the in-line type film forming apparatus having the a-Si:H film forming chambers constructed as described above. Then, the substrates were transported to the degassing chamber, and thereafter the substrates thus treated were transported to the first a-Si:H film forming chamber 103 to form therein the first a-Si:H film on each substrate.

The a-Si:H film was formed under conditions as follows: The insides of the plasma chamber 201 and film forming chamber 202 were evacuated to a vacuum of $10^{-4}$ Pa by means of a vacuum pump, and thereafter Ar gas was fed into the plasma chamber from the gas feeding means 207 at a flow rate of 200 sccm, and $SiH_4$ gas was fed into the film forming chamber from the gas feeding means 208 at a flow rate of 500 sccm so that the insides of the plasma chamber and film forming chamber were kept at a pressure of 1.3 Pa.

Next, a microwave with a frequency of 2.45 GHz and a power of 1.5 kW was introduced from a microwave power source into the ring waveguide through the microwave introducing portion to form the a-Si:H film. At this time, the wavelength in the waveguide was 159 mm. As a result, the formation of a first a-Si:H film of 72 nm thick was completed in about 5 to 6 seconds, and the a-Si:H film was deposited at a rate of about 800 nm/min. Immediately after the film formation, the temperature of each substrate was about 50°C.

After the first a-Si:H film had been formed, the resulting substrates were transported to the recording film forming chamber, where a Gd-Fe-Co film and a Tb-Fe-Co film were formed on each substrate by RF sputtering.

As a sputtering target, a Gd-Fe-Co alloy target of 150 mm × 470 mm and 6 mm thick or a Tb-Fe-Co alloy target with the same size was used. The RF sputtering was carried out under conditions as follows: The inside of the chamber was evacuated to a vacuum of $1 \times 10^{-5}$ Pa, and thereafter Ar gas was fed at a pressure of 0.1 Pa and a power density of 5.6 $W/cm^2$.

After the recording film had been formed, the resulting substrates were transported to the second a-Si:H film forming chamber 105 and the a-Si:H film was formed on each substrate under the same conditions as the formation of the first a-Si:H film. Thus, the second a-Si:H film was formed in 2 to 3 seconds.

Next, the resulting substrates were transported to the reflective film forming chamber, where an Al reflective film was formed on each substrate by sputtering. As a sputtering target, an Al target of 150 mm × 470 mm and 6 mm thick was used. The sputtering was carried out under conditions as follows: The inside of the chamber was evacuated to a vacuum of $1 \times 10^{-5}$ Pa, and thereafter Ar gas was fed at a pressure of 0.3 Pa and a power density of 5 to 7 $W/cm^2$.

Subsequently, the three substrates on which the above films had been formed were taken out of the in-line type film forming apparatus, and then a rubber type adhesive comprised of a mixture of 100 parts by weight of a styrene/butadiene copolymer (trade name: CALIFLEX TR1107; available from Shell Chemical Co.), 50 parts by weight of modified wood rosin and 1 part by weight of a stabilizer was applied on the Al reflective film in a thickness of 2 μm. Thereafter, on the pressure-sensitive adhesive layer formed, a film of 6 μm thick of cured urethane acrylate ultraviolet curable resin was superposed. Thus, magneto-optical disks were produced.

Evaluation on the three magneto-optical disks thus obtained in the same lot was made by measuring their C/N (carrier-to-noise) ratio and byte error rate (B.E.R.) on values at the initial stage and values obtained after standing in an environment of 80°C and 85%RH for 1,500 hours (hereinafter "after standing").

With regard to the C/N ratio and B.E.R., the magneto-optical disks were each set on a magneto-optical disk recording-reproducing detector (trade name: LN52A; manufactured by Shibasoku K.K.) and information was recorded and reproduced to measure the values.

The recording and reproducing were made under the following conditions.

| | |
|---|---|
| Linear velocity | 9.04 m/sec. |
| Recording frequency | 6 MHz |
| Recording power | 10 mW |
| Reproducing power | 1 mW |

(continued)

| Recording-reproducing wavelength | 830 nm |
|---|---|

Tilt angles of the magneto-optical disks thus produced were also measured using a tilt angle measuring device (trade name: LM-100; manufactured by Ono Sokuki K.K.).

Results thus obtained are shown in Table 1. In Table 1, in the evaluation of the C/N ratio after standing, an instance where the amount of changes before and after standing was less than 3 dB or less is evaluated as "A", an instance where it was 3 to 8 dB as "B", and an instance where it was more than 8 dB as "C".

With regard to B.E.R., an instance where the value after standing was on the same order as the initial stage value is evaluated as "A", an instance where the former increased by one order as "B", and an instance where the former increased by two or more orders as "C".

With regard to tilt angles, an instance where the changes were not more than 5 mrad is evaluated as "A", and an instance where they were more than 5 mrad as "B".

Stress and refractive index of the first a-Si:H films prepared by the plasma-assisted CVD described above were also measured in the following way.

Namely, under the same film forming conditions as described above, a-Si:H films were formed on glass disks of 30 mm diameter and 1.0 mm thick used for measuring stress, and any deformation of such substrates was detected as the number of Newton's rings by the use of an interferometer. Here, when the number of Newton's rings is represented by m, a curvature radium $\gamma$ is determined by the following expression (1).

$$\gamma = a^2/m\lambda \qquad (1)$$

wherein;

    a: a radius of the substrate; and
    $\lambda$: a wavelength of a light source used in the interferometer.

Now, substitution of the value of $\gamma$ for the following expression (2) can determine a stress $\sigma$ of the first a-Si:H film.

$$\sigma = Eb^2/6(1-\nu)\gamma d \qquad (2)$$

wherein;

    E: Young's modulus of the substrate;
    $\nu$: Poisson's ratio of the substrate;
    $\gamma$: curvature radius of the substrate;
    d: thickness of the a-Si:H film; and
    b: thickness of the substrate.

The refractive index of the the a-Si:H film is calculated from reflectance in spectral properties of a sample prepared by forming films on a glass substrate. Reflectance is measured on one sample at its ten spots arbitrarily selected and an average of the values of reflectance calculated therefrom is regarded as the refractive index of the sample.

To also measure thickness uniformity of the first a-Si:H films formed by the plasma-assisted CVD described above, three sheets of glass disks of 86 mm diameter and of 1.2 mm thick were prepared, and a-Si:H films of 72 nm thick were simultaneously formed thereon in entirely the same manner as the plasma-assisted CVD described above. The film thickness of each a-Si:H film was measured at its 20 points arbitrarily selected in a region between a circle of 24 mm radius and a circle of 40 mm radius on the disk (which region corresponds to the effective region of the magneto-optical disk). Then, its film thickness distribution was evaluated in the following way: An instance where the thicknesses at all measuring points are all within ±2.5% with respect to the standard thickness was evaluated as "AA"; an instance where the thickness at any one of measuring points is more than ±2.5% to not more than ±3% with respect to the standard thickness, as "A"; an instance where the thickness at any one of measuring points is more than ±3% to not more than ±5% with respect to the standard thickness, as "B"; and an instance where the thickness at any one of measuring points is more than ±5% with respect to the standard thickness, as "C".

Three sheets of disk substrates of 86 mm diameter and 1.2 mm thick, made of polycarbonate resin (trade name: IUPILON H4000; available from Mitsubishi Gas Chemical Company, Inc.) were newly prepared, and a-Si:H films of 200 nm thick were simultaneously formed thereon by plasma-assisted CVD in entirely the same procedure as described above. On the films thus formed, their adhesion to the substrate was measured by a cross-cut test.

The cross-cut test was made in the following way: First, cuts were made with a blade in the dielectric film formed on the substrate in such a way that 25 squares in total were formed having 3 mm side, and an adhesive tape with an adhesive force of 2 kgf/cm was stuck to that portion. Thereafter the tape was peeled off in the direction perpendicular to the film surface. This test was made at 6 spots arbitrarily selected per each disk.

Results thus obtained are shown in Table 1.

The adhesion was evaluated according to the following criterions.

A: No separation of dielectric films occurred at all the 6 spots where the cross-cut test was made.
B: Separation of 1 to 3 squares occurred at least one spot of the 6 spots where the cross-cut test was made.
C: Separation of more than 3 squares occurred at least one spot of the 6 spots where the cross-cut test was made.

Comparative Example 1

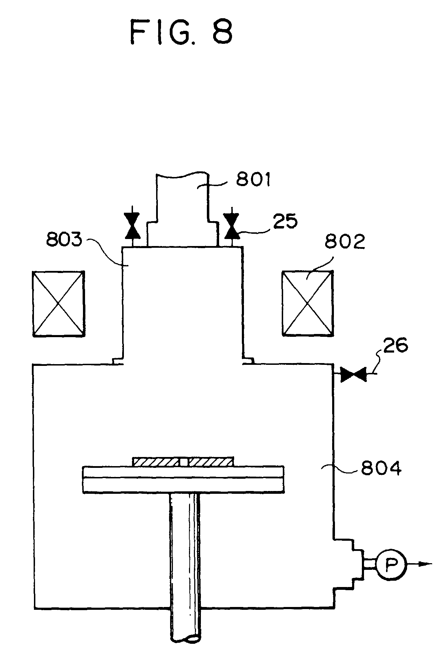

Example 1 was repeated to simultaneously produce three sheets of magneto-optical disks, except that the first a-Si:H film and second a-Si:H film forming devices used in Example 1 were each replaced with an electron cyclotron resonance (ECR) plasma-assisted CVD film forming device having as shown in Fig. 8 a means 801 for guiding microwaves into a plasma chamber 803 from one end of the plasma chamber, and a coil 802 for causing electron cyclotron resonance in the plasma inside the chamber.

In the present Comparative Example, the a-Si:H films were formed under conditions as follows: The internal stress of each a-Si:H film was so set as to be in the range of a stress (0 to -30 kg/mm$^2$) tolerable for inorganic dielectric films for magneto-optical disks. Stated specifically, microwaves with a frequency of 2.45 GHz were guided into the plasma chamber 803 from the waveguide 801 and also a magnetic field (.0875 tesla (875 gauss)) satisfying the conditions for electron cyclotron resonance was produced inside the chamber by means of the coil 802 provided on the outside of the chamber. The microwave power was adjusted to 500 W; the gas flow rate, to 10 sccm of $SiH_4$ and 30 sccm of Ar, and the gas pressure in the plasma chamber 803 and a film forming chamber 804 each, to 1.0 Pa. The plasma chamber 803, the film forming chamber 804 and the substrates were arranged in the same manner as in Example 1.

The internal stress of the a-Si:H films thus formed was -30 kg/mm$^2$ or less.

On the magneto-optical disks thus produced, evaluation was made in the same manner as in Example 1. As a result, no evaluation was possible on the disks other than the disk produced on the substrate positioned at the middle among the three substrates.

Properties of the a-Si:H films obtained by the process of the present Comparative Example were also observed in the same manner as in Example 1. As a result, as shown in Table 1, it was possible to uniformly form the dielectric film with a given thickness only on the substrate positioned at the middle among the three substrates, and also, even though the substrates are in the same lot, the dielectric films were seen to be formed in uneven thickness on these substrates. Thus, nothing was worth while to make evaluation other than the dielectric films formed on the substrate positioned at the middle among the three substrates.

The magneto-optical disk produced using the substrate positioned at the middle in the chamber, on which the dielectric film with a uniform thickness was formed, was seen to cause a great decrease in C/N ratio and a great increase in B.E.R. when stored in an environment of high temperature and high humidity. Also, their film forming rate was about 60 nm/min.

Table 1

| | C/N ratio | | B.E.R. | | | | Film thickness distri-bution | Refractive index | Adhe-sion | Dielectric stress |
|---|---|---|---|---|---|---|---|---|---|---|
| | Initial value | After standing | After standing | Tilt angle (mrad) | Film forming rate (nm/min) | Substrate temp. (°C) | | | | (kg/mm$^2$) |
| Example: | | | | | | | | | | |
| 1-1 | 46 | A | A | A | 800 | 50 | A | 3.7 | A | -3.0 |
| 1-2 | 46 | A | A | A | " | " | A | " | " | " |
| 1-3 | 46 | A | A | A | " | " | A | " | " | " |
| Comparative Example: | | | | | | | | | | |
| 1-1 | — | — | — | B | — | — | C | — | — | — |
| 1-2 | 46 | C | C | A | 60 | 50 | A | 3.7 | C | ≦-30 |
| 1-3 | — | — | — | B | — | — | C | — | — | — |

EP 0 626 683 B1

Example 2

Example 1 was repeated to produce magneto-optical disks, except that the magneto-optical disks were produced in the layer configuration as shown below and the first and second inorganic dielectric films were formed under conditions also shown below.

On the magneto-optical disks thus produced, evaluation was made in the same manner as in Example 1. Properties of the $Si_3N_4$ films formed by this process were also evaluated in the same manner as in Example 1. Results obtained are shown in Table 2.

| Configuration | Example 2 | |
|---|---|---|
| Reflective film | Al | 60 nm |
| 2nd dielectric film | $Si_3N_4$ | 30 nm |
| Recording film | GdFeCo/TbFeCo | 10/20 nm |
| 1st dielectric film | $Si_3N_4$ | 95 nm |
| Dielectric film, film forming conditions | | |
| Gas species | $SiH_4$, $N_2$ | |
| Exhaust pressure | $1 \times 10^{-4}$ Pa | |
| Gas pressure | 1.3 Pa | |
| Gas low rate | $SiH_4$: 200 sccm | |
| | $N_2$: 500 sccm | |
| Applied power | 1.5 kw | |

Comparative Example 3

Example 2 was repeated to simultaneously produce three sheets of magneto-optical disks, except that the first $Si_3N_4$ film and second $Si_3N_4$ film forming devices used in Example 2 were each replaced with an electron cyclotron resonance (ECR) plasma-assisted CVD film forming device having as shown in Fig. 8 a means 801 for guiding microwaves into a plasma chamber 803 from one end of the plasma chamber and a coil 802 for causing electron cyclotron resonance in the plasma inside the chamber.

In the present Comparative Example, the $Si_3N_4$ films were formed under conditions as follows: The internal stress of each $Si_3N_4$ film was so set as to be in the range of a stress (0 to -30 kg/mm$^2$) tolerable for inorganic dielectric films for magneto-optical disks. Stated specifically, microwaves with a frequency of 2.45 GHz were guided into the plasma chamber 803 from the waveguide 801 and also a magnetic field (.0875 tesla (875 gauss)) satisfying the conditions for electron cyclotron resonance was produced inside the chamber by means of the coil 802 provided on the outside of the chamber. The microwave power was adjusted to 650 W; the gas flow rate, to 10 sccm of $SiH_4$ and 30 sccm of $N_2$, and the gas pressure in the plasma chamber 803 and a film forming chamber 804 each, to 1.0 Pa. The plasma chamber 803, the film forming chamber 804 and the substrates were arranged in the same manner as in Example 1.

On the magneto-optical disks thus produced, evaluation was made in the same manner as in Example 1. As a result, no evaluation was possible on the disks other than the disk produced on the substrate positioned at the middle among the three substrates.

Properties of the $Si_3N_4$ films obtained by the process of the present Comparative Example were also observed in the same manner as in Example 1. As a result, as shown in Table 2, it was possible to uniformly form the dielectric film with a given thickness only on the substrate positioned at the middle among the three substrates, and also, even though the substrates are in the same lot, the dielectric films were seen to be formed in uneven thickness on these substrates. Thus, nothing was worth while to make evaluation other than the dielectric films formed on the substrate positioned at the middle among the three substrates.

The magneto-optical disk produced using the substrate positioned at the middle in the chamber, on which the dielectric film with a uniform thickness was formed, was seen to cause a great decrease in C/N ratio and a great increase in B.E.R. when stored in an environment of high temperature and high humidity. Also, their film forming rate was about 60 nm/min.

Table 2

| | C/N ratio | | B.E.R. | Tilt angle | Film forming rate | Substrate temp. | Film thickness distribution | Refractive index | Adhesion | Dielectric stress |
|---|---|---|---|---|---|---|---|---|---|---|
| | Initial value | After standing | After standing | angle (mrad) | rate (nm/min) | temp. (°C) | bution | index | sion | stress (kg/mm$^2$) |
| Example: | | | | | | | | | | |
| 3-1 | 48 | A | A | A | 850 | ≦50 | A | 2.0 | A | -2.0 |
| 3-2 | " | " | " | " | " | " | " | " | " | " |
| 3-3 | " | " | " | " | " | " | " | " | " | " |
| Comparative Example: | | | | | | | | | | |
| 2-1 | – | – | – | – | – | – | C | – | – | – |
| 2-2 | 48 | C | C | A | 60 | ≦50 | A | 2.0 | C | ≦-30 |
| 2-3 | – | – | – | – | – | – | C | – | – | – |

EP 0 626 683 B1

<u>Examples 3 to 8</u>

Example 1 was repeated to produce magneto-optical disks, except that the magneto-optical disks were produced in the layer configuration as shown in Table 3 and the first and second inorganic dielectric films were formed under conditions also shown in Table 3. Evaluation was also made similarly.

Properties of the inorganic dielectric films formed under the respective conditions were also evaluated in the same manner as in Example 1. Results obtained are shown in Table 4.

Table 3

| Configuration | Example 3 | | Example 4 | | Example 5 | |
|---|---|---|---|---|---|---|
| Reflective film: | Al | 60 nm | Al | 60 nm | Al | 60 nm |
| 2nd dielectric film: | a-Si:H | 30 nm | $Si_3N_4$ | 30 nm | $SiO_2$ | 30 nm |
| Recording film: | TbFeCo | 30 nm | TbFeCo | 20 nm | GdFeCo/TbFeCo | 10 nm/20 nm |
| 1st dielectric film: | a-Si:H | 57 nm | $Si_3N_4$ | 110 nm | $SiO_2$ | 95 nm |
| Dielectric film, film forming conditions | | | | | | |
| Gas species: | $SiH_4$, Ar | | $SiH_4$, $N_2$ | | $SiH_4$, $O_2$ | |
| Exhaust pressure: | $1\times10^{-4}$ Pa | | $1\times10^{-4}$ Pa | | $1\times10^{-4}$ Pa | |
| Gas pressure: | 1.3 Pa | | 1.3 Pa | | 1.3 Pa | |
| Gas flow rate: | $SiH_4$: 200 sccm | | $SiH_4$: 200 sccm | | $SiH_4$: 200 sccm | |
| | Ar: 300 sccm | | $N_2$: 1,000 sccm | | $O_2$: 500 sccm | |
| Applied power: | 1.5 kw | | 1.5 kw | | 1.5 kw | |

Table 3 (Cont')

| Configuration | Example 6 | | Example 7 | | Example 8 | |
|---|---|---|---|---|---|---|
| Reflective film: | Al | 60 nm | Al | 60 nm | Al | 60 nm |
| 2nd dielectric film: | $SiO_2$ | 30 nm | SiC | 30 nm | SiC | 30 nm |
| Recording film: | TbFeCo | 20 nm | GdFeCo/TbFeCo | 10 nm/20 nm | TbFeCo | 20 nm |
| 1st dielectric film: | $SiO_2$ | 95 nm | SiC | 85 nm | SiC | 110 nm |
| Dielectric film, film forming conditions | | | | | | |
| Gas species: | $SiH_4$, $O_2$ | | $SiH_4$, $C_2H_2$ | | $SiH_4$, Ar | |
| Exhaust pressure: | $1 \times 10^{-4}$ Pa | | $1 \times 10^{-4}$ Pa | | $1 \times 10^{-4}$ Pa | |
| Gas pressure: | 1.3 Pa | | 1.3 Pa | | 1.3 Pa | |
| Gas flow rate: | $SiH_4$: 200 sccm | | $SiH_4$: 200 sccm | | $SiH_4$: 200 sccm | |
| | $O_2$: 800 sccm | | $C_2H_2$: 200 sccm | | $C_2H_2$: 400 sccm | |
| Applied power: | 1.5kw | | 1.5kw | | 1.5kw | |

EP 0 626 683 B1

Example 9

Example 3 was repeated to produce phase change optical disks, except that the magneto-optical recording films in Example 3 was replaced with recording films comprised of an Sb-Te alloy and formed by magnetron sputtering.

On the resulting optical disks, the respective properties were evaluated in the same manner as in Example 3.

Results obtained are shown in Table 4.

In the present Example, the C/N ratio and B.E.R. of the optical disks were measured using an optical disk evaluation device (trade name: OMS-2000; manufactured by Nakamichi K.K.).

Table 4

| | C/N ratio | | B.E.R. | | | | Film thick-ness distri-bution | Refrac-tive index | Adhe-sion | Dielec-tric stress |
|---|---|---|---|---|---|---|---|---|---|---|
| | Initial value | After standing | After standing | Tilt angle | Film forming rate | Sub-strate temp. | | | | |
| | | | | (mrad) | (nm/min) | (°C) | | | | (kg/mm$^2$) |
| Example: | | | | | | | | | | |
| 3-1 | 46 | A | A | A | 800 | 50 | A | 3.7 | A | -3.0 |
| 3-2 | 46 | A | A | A | 800 | 50 | A | 3.7 | A | -3.0 |
| 3-3 | 46 | A | A | A | 800 | 50 | A | 3.7 | A | -3.0 |
| 4-1 | 48 | A | A | A | 950 | ≦50 | A | 1.8 | A | -2.0 |
| 4-2 | 48 | A | A | A | 950 | ≦50 | A | 1.8 | A | -2.0 |
| 4-3 | 48 | A | A | A | 950 | ≦50 | A | 1.8 | A | -2.0 |
| 5-1 | 48 | A | A | A | 850 | ≦50 | A | 2.0 | A | -2.0 |
| 5-2 | 48 | A | A | A | 850 | ≦50 | A | 2.0 | A | -2.0 |
| 5-3 | 48 | A | A | A | 850 | ≦50 | A | 2.0 | A | -2.0 |
| 6-1 | 48 | A | A | A | 950 | ≦50 | A | 1.7 | A | -2.0 |
| 6-2 | 48 | A | A | A | 950 | ≦50 | A | 1.7 | A | -2.0 |
| 6-3 | 48 | A | A | A | 950 | ≦50 | A | 1.7 | A | -2.0 |
| 7-1 | 47 | A | A | A | 950 | ≦65 | A | 1.9 | A | -2.0 |
| 7-2 | 47 | A | A | A | 950 | ≦65 | A | 1.9 | A | -2.0 |
| 7-3 | 47 | A | A | A | 950 | ≦65 | A | 1.9 | A | -2.0 |
| 8-1 | 47 | A | A | A | 950 | ≦65 | A | 1.7 | A | -2.0 |
| 8-2 | 47 | A | A | A | 950 | ≦65 | A | 1.7 | A | -2.0 |
| 8-3 | 47 | A | A | A | 950 | ≦65 | A | 1.7 | A | -2.0 |
| 9-1 | 47 | A | A | A | 850 | ≦50 | A | 2.0 | A | -2.0 |
| 9-2 | 47 | A | A | A | 850 | ≦50 | A | 2.0 | A | -2.0 |
| 9-3 | 47 | A | A | A | 850 | ≦50 | A | 2.0 | A | -2.0 |

EP 0 626 683 B1

Example 10

Five sheets of magneto-optical disks having the same layer configuration as the magneto-optical disks produced in Example 4 were simultaneously produced using the inorganic dielectric film forming device as shown in Fig. 6.

The Fig. 6 film forming device used in the present Example was comprised of a plasma chamber with a length of 532 in the substrate transport direction, a height of 144 mm and a width of 182 mm, and a film forming chamber with a length of 526 mm, a width of 182 mm and a height of 100 mm. The ring waveguide used herein had a width 27 mm and a height of 96 mm as the size of a cross section of the empty space of the waveguide, and had a such a shape that its inner wall was in substantially close contact with the outer wall of the plasma chamber. The inner surface of this waveguide was coated with copper and further coated thereon with silver. The inner wall 607 of the waveguide was provided with 40 rectangular slots of 42 mm long and 3 mm wide at intervals of 40 mm.

As the dividing block, a block having a cross section of a right-angled isosceles triangle, the longer side of which was 27 mm, made of aluminum, was welded to the ring waveguide inner wall at its position opposing the microwave introducing portion so that the microwaves were equally divided in the both directions inside the waveguide.

As reflective blocks, blocks made of aluminum, each having a right-angled isosceles triangle in a cross section and short sides of 27 mm long were welded to the respective corners of the inner wall of the ring waveguide as shown in Fig. 6B.

The first and second $Si_3N_4$ films were formed under conditions as shown below.

| Film forming conditions | |
|---|---|
| Gas species | $SiH_4$, $N_2$ |
| Exhaust pressure | $1 \times 10^{-4}$ Pa |
| Gas pressure | 1.3 Pa |
| Gas flow rate | $SiH_4$: 200 sccm |
| | $N_2$: 1,000 sccm |
| Applied power | 1.5 kw |
| Frequency | 2.45 GHz |

The $SiH_4$ gas was fed into the film forming chamber from the gas feeding means 612, and $N_2$ gas was fed into the plasma chamber from the gas feeding means 611 to form the $Si_3N_4$ films on the substrates arranged in series in the direction of substrate transport in the film forming chamber.

In the present Example, the magneto-optical disks were produced in entirely the same manner as in Example 4 except for the manner by which the first $Si_3N_4$ film and the second $Si_3N_4$ film were formed. On the magneto-optical disks thus produced, evaluation was made in the same manner as in Example 1, and also the properties of the $Si_3N_4$ films obtained by the process of the present Example were evaluated in the same manner as in Example 1.

Results obtained are shown in Table 5.

Example 11

Example 10 was repeated to produce magneto-optical disks, except that $SiH_4$ gas and $N_2$ gas were mixed and the mixed gas was fed into the plasma chamber from the gas feeding means 611.

On the magneto-optical disks thus obtained, evaluation was made in the same manner as in Example 1 and also the properties of the $Si_3N_4$ films obtained by the present process were evaluated in the same manner as in Example 1.

Results obtained are shown in Table 5.

Table 5

| | C/N ratio | | B.E.R. | | | | Film thick-ness distri-bution | Refrac-tive index | Adhe-sion | Dielec-tric stress |
| | Initial value | After standing | After standing | Tilt angle (mrad) | Film forming rate (nm/min) | Sub-strate temp. (°C) | | | | $(kg/mm^2)$ |
|---|---|---|---|---|---|---|---|---|---|---|
| Example: | | | | | | | | | | |
| 10-1 | 48 | A | A | A | 950 | ≦50 | A | 1.8 | A | -2.0 |
| 10-2 | 48 | A | A | A | 950 | ≦50 | A | 1.8 | A | -2.0 |
| 10-3 | 48 | A | A | A | 950 | ≦50 | A | 1.8 | A | -2.0 |
| 10-4 | 48 | A | A | A | 950 | ≦50 | A | 1.8 | A | -2.0 |
| 10-5 | 48 | A | A | A | 950 | ≦50 | A | 1.8 | A | -2.0 |
| Example: | | | | | | | | | | |
| 11-1 | 48 | A | A | A | 600 | ≦50 | A | 1.9 | A | -2.0 |
| 11-2 | 48 | A | A | A | 600 | ≦50 | A | 1.9 | A | -2.0 |
| 11-3 | 48 | A | A | A | 600 | ≦50 | A | 1.9 | A | -2.0 |
| 11-4 | 48 | A | A | A | 600 | ≦50 | A | 1.9 | A | -2.0 |
| 11-5 | 48 | A | A | A | 600 | ≦50 | A | 1.9 | A | -2.0 |

EP 0 626 683 B1

## Claims

1. A microwave processing apparatus (103, 105) comprising:

   a plasma chamber (201; 606);
   gas feeding means (207; 611; 708) and a waveguide (205; 601; 701) provided with a microwave introducing portion (206; 603; 702),
   the apparatus being characterised in that:
   the waveguide is an endless waveguide (205; 601; 701) surrounding the plasma chamber (201; 602), the endless waveguide comprising:
   an inner wall (205-1; 607; 703) and an outer wall (205-2) between which a cavity (205-3) is provided, wherein the inner wall (205-1; 607; 703) has a plurality of slots (301; 608; 704) at given intervals in order to enable the introduction of microwaves into the plasma chamber (201; 601);

   and in that the apparatus comprises:
   a dividing block (302; 609; 706) on the inner wall (205-1; 607; 703) at a position so as to be collided with by the microwaves introduced into the endless waveguide (205; 601; 701) from the microwave introducing portion (206; 603) thereby to divide the introduced microwaves and to propagate the microwaves along both directions of the endless waveguide (205; 601; 701).

2. An apparatus according to claim 1, wherein the microwave processing device (103, 105) further comprises a film forming chamber (202; 602).

3. An apparatus according to claim 2, wherein said film forming chamber is provided with a gas feeding means (207, 208; 612).

4. An apparatus according to claim 1, wherein said plurality of slots are provided at intervals corresponding to ½ times the wavelength of the microwaves to be guided into said endless waveguide where n is an integer.

5. An apparatus according to claim 1, wherein said microwave introducing portion (206; 603) is provided such that the microwaves are introduced in the direction of the centre of said endless waveguide (205; 601; 701).

6. An apparatus according to claim 1, wherein the endless waveguide (205; 601; 701) is provided with a magnetic field generating means in the vicinity of said slots (301; 608; 704) provided along the periphery of said inner wall (205-1; 607; 703) thereof.

7. An apparatus according to any one of claims 1 to 6, wherein said plasma chamber (606) has a cavity of rectangular cross section.

8. An apparatus according to any one of claims 1 to 6, wherein said plasma chamber (201) is cylindrical.

9. A process for producing an inorganic dielectric film (402, 403) on a substrate by microwave plasma assisted Chemical vapor deposition (CVD) using an apparatus according to claims 1 to 8.

10. The process according to claim 9, wherein said inorganic dielectric film (402, 403) is formed by the reaction of a plurality of species of gases.

11. The process according to claim 10, wherein the plurality of species of gases comprise a reaction gas and a starting material gas.

12. The process according to claim 11 when dependent on claim 3, wherein said reaction gas is fed into the plasma chamber (201; 602) through a first gas feeding means (207; 611), and the starting material gas is fed into the film forming chamber (202; 602) through a second gas feeding means (208; 612).

13. The process according to claim 11 or 12, wherein the starting material gas is selected from the group consisting of inorganic silanes, organic silanes and halosilanes and a halogenated metal compound and the reaction gas is selected from a group consisting of $O_2$, $O_3$, $H_2O$, NO, $N_2O$, $NO_2$, $N_2$, $NH_3$, $N_2H_4$ and hexamethyldisilazane to form the inorganic dielectric film comprising SiN, SiO and $SiO_2$.

**14.** The process according to claim 9, wherein the inorganic dielectric film is made of a-Si or SiC.

**15.** The process according to claim 14, wherein inorganic silanes, organic silanes or halosilanes are fed into the plasma chamber (201; 606) through the gas feeding means (207; 611; 708).

**16.** The process according to claim 13 or 14, wherein said inorganic silanes contain at least one of $SiH_4$ and $Si_2H_6$.

**17.** The process according to claim 13, wherein said organic silanes include at least one of tetraethoxylsilane, tetramethoxylsilane and octamethylcyclotetrasilane.

**18.** The process according to claim 13 or 14, wherein said halosilanes include at least one of $SiF_4$, $Si_2F_6$, $SiH_2F_2$, $SiCl_4$, $Si_2Cl_6$, $SiHCl_3$, $SiH_2Cl_2$, $SiH_3Cl$ and $SiCl_2F_2$.

**19.** The process according to claim 11 or 12, wherein the starting material gas is selected from the group consisting of organic metal compounds and halogenated metal compounds and the reaction gas is selected from a group consisting of $O_2$, $O_3$, $H_2O$, $NO$, $N_2O$, $NO_2$, $N_2$, $NH_3$, $N_2H_4$ and hexamethyldisilazane to form the inorganic dielectric film comprising AlN, $Al_2O_3$, $TiO_2$ or $Ta_2O_5$.

**20.** The process according to claim 19, wherein the organic metal compounds include at least one of trimethyl aluminium, triethyl aluminium, triisobutyl aluminium or dimethylaluminum hydride.

**21.** The process according to claim 19, wherein the halogenated metal compounds include at least one of $AlCl_3$, $TiCl_3$ and $TaCl_5$.

**22.** The process according to claim 15, wherein said organic silanes include at least one of tetraethylsilane, tetramethylsilane and dimethylsilane.

**23.** A process for producing an optical recording medium comprising a recording film (401) and an inorganic dielectric film (402, 403) including the steps of forming a recording film and forming an inorganic dielectric film using a process according to any one of claims 9 to 22.

**24.** The process according claim 23, wherein said recording film (401) contains at least one of a rare earth element and a transition metal.

**25.** The process according to claim 24, wherein said recording film (401) is an amorphous magnetic recording film.

**26.** The process according to claim 23, wherein said recording film (401) contains a calcogenide element.

**27.** The process according to any one of claims 23 to 26, including the step of providing a reflective layer (404).

**28.** The process according to any one of claims 23 to 27, including the step of providing a protective layer on the medium.

**29.** The process according to any one of claims 23 to 28, in which the inorganic dielectric film is deposited on the recording film (401).

**30.** The process according to any one of claims 23 to 27 in which the medium includes two said inorganic dielectric films and the process includes the steps of depositing the first inorganic dielectric film (402) directly on the substrate, and the second inorganic dielectric film (403) over the recording film (401).

**Patentansprüche**

**1.** Mikrowellen-Bearbeitungsvorrichtung (103, 105), umfassend:

einen Plasmaraum (201; 606);
Gaszuführeinrichtung (207; 611, 708) und einen Wellenleiter (205; 601; 701), der mit einem Mikrowellen-einführenden Abschnitt (206; 603; 702) ausgestattet ist,

wobei die Vorrichtung dadurch gekennzeichnet ist, daß:
der Wellenleiter ein den Plasmaraum (201; 602) umgebender, endloser Wellenleiter (205; 601; 701) ist, wobei der endlose Wellenleiter umfaßt:
eine Innenwand (205-1; 607; 703) und eine Außenwand (205-2), zwischen denen ein Hohlraum (205-3) geschaffen ist, wobei die Innenwand (205-1; 607; 703) eine Vielzahl an Schlitzen (301; 608; 704) an gegebenen Abständen besitzt, um die Einführung von Mikrowellen in den Plasmaraum (201; 601) zu ermöglichen;

und dadurch, daß die Vorrichtung umfaßt:
einen Teilungsblock (302; 609; 706) auf der Innenwand (205-1; 607, 703) an einer Position derart, daß er von den von dem Mikrowellen-einführenden Abschnitt (206; 603) in den endlosen Wellenleiter (205; 601; 701) eingeführten Mikrowellen kollidiert wird, um auf diese Weise die eingeführten Mikrowellen zu teilen und die Mikrowellen entlang beider Richtungen des endlosen Wellenleiters (205; 601; 701) auszubreiten.

2. Vorrichtung nach Anspruch 1, wobei die Mikrowellen-Bearbeitungsvorrichtung (103, 105) ferner einen Filmbildungsraum (202; 602) umfaßt.

3. Vorrichtung nach Anspruch 2, wobei der Filmbildungsraum mit einer Gaszuführeinrichtung (207, 208; 612) ausgestattet ist.

4. Vorrichtung nach Anspruch 1, wobei die Vielzahl an Schlitzen an Abständen entsprechend den Vielfachen von 1/2 der Wellenlänge der in den endlosen Wellenleiter einzuführenden Mikrowellen angebracht ist, wobei n eine ganze Zahl ist.

5. Vorrichtung nach Anspruch 1, wobei der Mikrowelleneinführende Abschnitt (206; 603) derart angeordnet ist, daß die Mikrowellen in Richtung der Mitte des endlosen Wellenleiters (205; 601; 701) eingeführt werden.

6. Vorrichtung nach Anspruch 1, wobei der endlose Wellenleiter (205; 601; 701) mit einer Magnetfelderzeugungseinrichtung in der Nähe der entlang des Umfangs seiner Innenwand (205-1; 607; 703) angebrachten Schlitze (301; 608; 704) ausgestattet ist.

7. Vorrichtung nach einem der Ansprüche 1 bis 6, wobei der Plasmaraum (606) einen Hohlraum mit rechtwinkligem Querschnitt besitzt.

8. Vorrichtung nach einem der Ansprüche 1 bis 6, wobei der Plasmaraum (201) zylindrisch ist.

9. Verfahren zur Herstellung eines anorganischen, dielektrischen Films (402, 403) auf einem Substrat durch Mikrowellenplasma-unterstützte chemische Dampfabscheidung (CVD) unter Verwendung einer Vorrichtung gemäß den Ansprüchen 1 bis 8.

10. Verfahren nach Anspruch 9, wobei der anorganische, dielektrische Film (402, 403) durch Reaktion einer Vielzahl von Gasarten gebildet wird.

11. Verfahren nach Anspruch 10, wobei die Vielzahl an Gasarten ein Reaktionsgas sowie ein Ausgangsmaterialgas umfaßt.

12. Verfahren nach Anspruch 11 im Fall der Abhängigkeit von Anspruch 3, wobei das Reaktionsgas durch eine erste Gaszuführeinrichtung (207; 611) in den Plasmaraum (201; 602) zugeführt wird und das Ausgangsmaterialgas durch eine zweite Gaszuführeinrichtung (208; 612) in den Filmbildungsraum (202; 602) zugeführt wird.

13. Verfahren nach Anspruch 11 oder 12, wobei das Ausgangsmaterialgas aus der Gruppe, bestehend aus anorganischen Silanen, organischen Silanen und Halogensilanen und einer halogenierten Metallverbindung, ausgewählt wird und das Reaktionsgas aus einer Gruppe, bestehend aus $O_2$, $O_3$, $H_2O$, NO, $N_2O$, $NO_2$, $N_2$, $NH_3$, $N_2H_4$ und Hexamethyldisilazan, ausgewählt wird, um den anorganischen, dielektrischen Film, der SiN, SiO und $SiO_2$ umfaßt, zu bilden.

14. Verfahren nach Anspruch 9, wobei der anorganische, dielektrische Film aus a-Si oder SiC hergestellt wird.

15. Verfahren nach Anspruch 14, wobei anorganische Silane, organische Silane oder Halogensilane durch die Gaszuführeinrichtung (207; 611; 708) in den Plasmaraum (201; 606) zugeführt werden.

16. Verfahren nach Anspruch 13 oder 14, wobei die anorganischen Silane mindestens eines aus $SiH_4$ oder $Si_2H_6$ enthalten.

17. Verfahren nach Anspruch 13, wobei die organischen Silane mindestens eines aus Tetraethoxylsilan, Tetramethoxylsilan und Octamethylcyclotetrasilan einschließen.

18. Verfahren nach Anspruch 13 oder 14, wobei die Halogensilane mindestens eines aus SiF4, $Si_2F_6$, $SiH_2F_2$, $SiCl_4$, $Si_2Cl_6$, $SiHCl_3$, $SiH_2Cl_2$, $SiH_3Cl$ und $SiCl_2F_2$ einschließen.

19. Verfahren nach Anspruch 11 und 12, wobei das Ausgangsmaterialgas aus der Gruppe, bestehend aus organischen Metallverbindungen und halogenierten Metallverbindungen, ausgewählt wird und das Reaktionsgas aus einer Gruppe, bestehend aus $O_2$, $O_3$, $H_2O$, NO, $N_2O$, $NO_2$, $N_2$, $NH_3$, $N_2H_4$ und Hexamethyldisilazan, ausgewählt wird, um den anorganischen, dielektrischen Film, der AIN, $Al_2O_3$, $TiO_2$ oder $Ta_2O_5$ umfaßt, zu bilden.

20. Verfahren nach Anspruch 19, wobei die organischen Metallverbindungen mindestens eine aus Trimethylaluminium, Triethylaluminium, Triisobutylaluminium oder Dimethylaluminiumhydrid einschließen.

21. Verfahren nach Anspruch 19, wobei die halogenierten Metallverbindungen mindestens eine aus $AlCl_3$, $TiCl_3$ und $TaCl_5$ einschließen.

22. Verfahren nach Anspruch 15, wobei die organischen Silane mindestens eines aus Tetraethylsilan, Tetramethylsilan und Dimethylsilan einschließen.

23. Verfahren zur Herstellung eines optischen Aufzeichnungsmediums, das einen Aufzeichnungsfilm (401) und einen anorganischen, dielektrischen Film (402, 403) umfaßt, einschließlich der Schritte der Bildung eines Aufzeichnungsfilms und der Bildung eines anorganischen, dielektrischen Films unter Verwendung eines Verfahrens gemäß einem der Ansprüche 9 bis 22.

24. Verfahren nach Anspruch 23, wobei der Aufzeichnungsfilm (401) mindestens eines von einem Seltenerdelement und einem Übergangsmetall enthält.

25. Verfahren nach Anspruch 24, wobei der Aufzeichnungsfilm (401) ein amorpher, magnetischer Aufzeichnungsfilm ist.

26. Verfahren nach Anspruch 23, wobei der Aufzeichnungsfilm (401) ein Chalkogenelement enthält.

27. Verfahren nach einem der Ansprüche 23 bis 26, einschließlich des Schritts der Anbringung einer reflektierenden Schicht (404).

28. Verfahren nach einem der Ansprüche 23 bis 27, einschließlich des Schritts der Anbringung einer Schutzschicht auf dem Medium.

29. Verfahren nach einem der Ansprüche 23 bis 28, bei dem der anorganische, dielektrische Film auf dem Aufzeichnungsfilm (401) aufgebracht wird.

30. Verfahren nach einem der Ansprüche 23 bis 27, bei dem das Medium zwei anorganische, dielektrische Filme einschließt und das Verfahren die Schritte des Aufbringens des ersten anorganischen, dielektrischen Films (402) direkt auf dem Substrat und des zweiten anorganischen, dielektrischen Films (403) über dem Aufzeichnungsfilm (401) einschließt.

**Revendications**

1. Appareil (103, 105) de traitement par micro-ondes comportant :

    une chambre à plasma (201 ; 606) ;

des moyens (207 ; 611 ; 708) d'amenée de gaz et un guide d'ondes (205 ; 601 ; 701) pourvu d'une partie (206 ; 603 ; 702) d'introduction de micro-ondes,

l'appareil étant caractérisé en ce que :

le guide d'ondes est un guide d'ondes sans fin (205 ; 601 ; 701) entourant la chambre à plasma (201 ; 602), le guide d'ondes sans fin comportant :

une paroi intérieure (205-1 ; 607 ; 703) et une paroi extérieure (205-2) entre lesquelles une cavité (205-3) est formée, la paroi intérieure (205-1 ; 607 ; 703) ayant plusieurs fentes (301 ; 608 ; 704) à intervalles donnés pour permettre l'introduction de micro-ondes dans la chambre à plasma (201 ; 601) ;

et en ce que l'appareil comporte :

un bloc de division (302 ; 609 ; 706) sur la paroi intérieure (205-1 ; 607 ; 703) dans une position telle qu'il est heurté par les micro-ondes introduites dans le guide d'ondes sans fin (205 ; 601 ; 701) depuis la partie d'introduction de micro-ondes (206 ; 603), de façon à diviser les micro-ondes introduites et à propager les micro-ondes dans les deux sens le long du guide d'ondes sans fin (205 ; 601 ; 701).

2. Appareil selon la revendication 1, dans lequel le dispositif (103, 105) de traitement par micro-ondes comporte en outre une chambre (202 ; 602) de formation de film.

3. Appareil selon la revendication 2, dans lequel ladite chambre de formation de film est pourvue d'un moyen (207 ; 208 ; 612) d'amenée de gaz.

4. Appareil selon la revendication 1, dans lequel lesdites fentes sont placées à des intervalles correspondant à la moitié de la longueur d'onde des micro-ondes devant être guidées dans ledit guide d'ondes sans fin, où $n$ est un entier.

5. Appareil selon la revendication 1, dans lequel ladite partie (206 ; 603) d'introduction de micro-ondes est prévue de façon que les micro-ondes soient introduites dans la direction du centre du guide d'ondes sans fin (205 ; 601 ; 701).

6. Appareil selon la revendication 1, dans lequel le guide d'ondes sans fin (205 ; 601 ; 701) est pourvu d'un moyen de génération d'un champ magnétique au voisinage desdites fentes (301 ; 608 ; 704) se trouvant le long de la périphérie de ladite paroi intérieure (205-1 ; 607 ; 703) de ce guide d'ondes.

7. Appareil selon l'une quelconque des revendications 1 à 6, dans lequel ladite chambre à plasma (606) présente une cavité de section transversale rectangulaire.

8. Appareil selon l'une quelconque des revendications 1 à 6, dans lequel ladite chambre à plasma (201) est cylindrique.

9. Procédé pour la production d'un film diélectrique inorganique (402, 403) sur un substrat par dépôt chimique en phase vapeur (CVD) assisté par plasma hyperfréquence, utilisant un appareil selon les revendications 1 à 8.

10. Procédé selon la revendication 9, dans lequel ledit film diélectrique inorganique (402, 403) est formé par la réaction de plusieurs espèces gazeuses.

11. Procédé selon la revendication 10, dans lequel les espèces gazeuses comprennent un gaz de réaction et un gaz de matière de départ.

12. Procédé selon la revendication 11 lorsqu'elle dépend de la revendication 3, dans lequel ledit gaz de réaction est introduit dans la chambre à plasma (201 ; 602) par l'intermédiaire d'un premier moyen (207 ; 611) d'amenée de gaz, et le gaz de matière de départ est introduit dans la chambre (202 ; 602) de formation de film par l'intermédiaire d'un second moyen (208 ; 612) d'amenée de gaz.

13. Procédé selon la revendication 11 ou 12, dans lequel le gaz de matière de départ est choisi dans le groupe constitué de silanes inorganiques, de silanes organiques et d'halosilanes et d'un composé métallique halogéné et le gaz de réaction est choisi dans le groupe constitué de $O_2$, $O_3$, $H_2O$, NO, $N_2O$, $NO_2$, $N_2$, $NH_3$, $N_2H_4$ et d'hexaméthyldisilazane pour former le film diélectrique inorganique comprenant SiN, SiO et $SiO_2$.

**14.** Procédé selon la revendication 9, dans lequel le film diélectrique inorganique est formé de a-Si ou de SiC.

**15.** Procédé selon la revendication 14, dans lequel des silanes inorganiques, des silanes organiques ou des halosilanes sont introduits dans la chambre à plasma (201 ; 606) par l'intermédiaire des moyens d'amenée de gaz (207 ; 611 ; 708).

**16.** Procédé selon la revendication 13 ou 14, dans lequel lesdits silanes inorganiques contiennent au moins l'un de $SiH_4$ et de $Si_2H_6$.

**17.** Procédé selon la revendication 13, dans lequel lesdits silanes organiques comprennent au moins l'un des tétraéthoxylsilane, tétraméthoxylsilane et octaméthylcyclotétrasilane.

**18.** Procédé selon la revendication 13 ou 14, dans lequel lesdits halosilanes comprennent au moins l'un des $SiF_4$, $Si_2F_6$, $SiH_2F_2$, $SiCl_4$, $Si_2Cl_6$, $SiHCl_3$, $SiH_2Cl_2$, $SiH_3Cl$ et $SiCl_2F_2$.

**19.** Procédé selon la revendication 11 ou 12, dans lequel le gaz de matière de départ est choisi dans le groupe constitué de composés organométalliques et de composés métalliques halogénés et le gaz de réaction est choisi dans un groupe constitué de $O_2$, $O_3$, $H_2O$, NO, $N_2O$, $NO_2$, $N_2$, $NH_3$, $N_2H_4$ et d'hexaméthyldisilazane pour former le film diélectrique inorganique comprenant AlN, $Al_2O_3$, $TiO_2$ ou $Ta_2O_5$.

**20.** Procédé selon la revendication 19, dans lequel les composés organométalliques comprennent au moins l'un du triméthylaluminium, du triéthylaluminium, du triisobutylaluminium ou de l'hydrure de diméthylaluminium.

**21.** Procédé selon la revendication 19, dans lequel les composés métalliques halogénés comprennent au moins l'un de $AlCl_3$, $TiCl_3$ et $TaCl_5$.

**22.** Procédé selon la revendication 15, dans lequel lesdits silanes organiques comprennent au moins l'un des tétraéthylsilane, tétraméthylsilane et diméthylsilane.

**23.** Procédé pour la production d'un support d'enregistrement optique comportant un film d'enregistrement (401) et un film diélectrique inorganique (402, 403), comprenant les étapes de formation d'un film d'enregistrement et de formation d'un film diélectrique inorganique en utilisant un procédé selon l'une quelconque des revendications 9 à 22.

**24.** Procédé selon la revendication 23, dans lequel ledit film d'enregistrement (401) contient au moins l'un d'un élément des terres rares et d'un métal de transition.

**25.** Procédé selon la revendication 24, dans lequel ledit film d'enregistrement (401) est un film d'enregistrement magnétique amorphe.

**26.** Procédé selon la revendication 23, dans lequel ledit film d'enregistrement (401) contient un élément des chalcogénures.

**27.** Procédé selon l'une quelconque des revendications 23 à 26, comprenant l'étape de réalisation d'une couche réfléchissante (404).

**28.** Procédé selon l'une quelconque des revendications 23 à 27, comprenant l'étape de réalisation d'une couche protectrice sur le support.

**29.** Procédé selon l'une quelconque des revendications 23 à 28, dans lequel le film diélectrique inorganique est déposé sur le film d'enregistrement (401).

**30.** Procédé selon l'une quelconque des revendications 23 à 27, dans lequel le support comprend deux desdits films diélectriques inorganiques et le procédé comprend les étapes de dépôt du premier film diélectrique inorganique (402) directement sur le substrat, et du second film diélectrique inorganique (403) sur le film d'enregistrement (401).

FIG. 1

FIG. 2A

FIG. 2B

EP 0 626 683 B1

# FIG. 3A

# FIG. 3B

30

# FIG. 4A

403
401
402

# FIG. 4B

404
403
401
402

# FIG. 5

206

205

205-2

205-1

205-3

301

FIG. 6A

603
B
606
601
B
611
604
C
612
602
100
605
C

FIG. 6B

610
609
603
606
607
601
608
613
614

FIG. 6C

606
601
604
602
605

EP 0 626 683 B1

## FIG. 7A

## FIG. 7B

# FIG. 8

# FIG. 9